# FASCICULE DE BREVET EUROPEEN

(11) **EP 3 384 593 B1**
(45) Date de publication et mention de la délivrance du brevet: **11.03.2020**
(21) Numéro de dépôt: 16806040.8
(22) Date de dépôt: 01.12.2016
(51) Int. Cl.: H02S 50/00, H02S 50/10

(54) **PROCÉDÉ ET DISPOSITIF DE DÉTECTION D'UN ARC ÉLECTRIQUE PARASITE DANS UNE INSTALLATION PHOTOVOLTAÏQUE**
VERFAHREN UND VORRICHTUNG ZUR ERKENNUNG VON PARASITÄREN LICHTBÖGEN IN EINER FOTOVOLTAIKANLAGE
METHOD AND DEVICE FOR DETECTING A PARASITIC ELECTRIC ARC IN A PHOTOVOLTAIC INSTALLATION

(30) Priorité: 01.12.2015 FR 1561626
(43) Date de publication de la demande: 10.10.2018
(73) Titulaire: Commissariat à l'Énergie Atomique et aux Énergies Alternatives, 75015 Paris (FR)
(72) Inventeur: CHAINTREUIL, Nicolas, 73800 Montmélian (FR); SIAT, Stéphane, 67230 Obenheim (FR)
(74) Mandataire: Novaimo
(86) Numéro de dépôt international: PCT/EP2016/079467
(87) Numéro de publication internationale: WO 2017/093421

(56) Documents cités:
- FR-A1- 3 002 645
- KOSTYANTYN KOZIY ET AL: "A Low-Cost Power-Quality Meter With Series Arc-Fault Detection Capability for Smart Grid", IEEE TRANSACTIONS ON POWER DELIVERY, IEEE SERVICE CENTER, NEW YORK, NY, US, vol. 28, no. 3, 1 juillet 2013 (2013-07-01), pages 1584-1591, XP011515987, ISSN: 0885-8977, DOI: 10.1109/TPWRD.2013.2251753
- SCHIMPF F ET AL: "Recognition of electric arcing in the DC-wiring of photovoltaic systems", INTELEC 09 : 31ST INTERNATIONAL TELECOMMUNICATIONS ENERGY CONFERENCE ; INCHEON, KOREA, 18 - 22 OCTOBER 2009, IEEE, PISCATAWAY, NJ, USA, 18 octobre 2009 (2009-10-18), pages 1-6, XP031579534, ISBN: 978-1-4244-2490-0

## Description

### Domaine technique de l'invention

L'invention concerne un procédé et un dispositif de détection d'un arc électrique parasite dans une installation photovoltaïque. Elle concerne aussi une installation photovoltaïque équipée d'un tel dispositif.

### État de la technique

Les installations photovoltaïques ont la caractéristique de fonctionner à courant et tension électriques continues. Cela s'avère problématique en cas d'apparition d'un arc électrique, ce qui peut se produire dans des conducteurs ou connexions défectueuses (par exemple suite à l'ouverture d'un connecteur en charge ou du fait de la corrosion d'un conducteur). En courant et tension continus, il n'y a pas d'extinction naturelle de l'arc électrique par passage par zéro de la tension et du courant, comme c'est le cas en courant alternatif. Il en résulte que l'arc électrique qui se produit au sein d'une installation photovoltaïque est susceptible de générer un plasma, dégageant une très forte chaleur, pendant une durée importante. Un tel plasma est destructeur et peut provoquer un début d'incendie. Pour des raisons de sécurité, il est donc indispensable de détecter la présence d'un éventuel arc électrique au sein d'une installation photovoltaïque et de l'interrompre en temps utile afin d'éviter toute dégradation ou début d'incendie. A cet effet, l'installation photovoltaïque est équipée d'un dispositif de détection d'arc, ou détecteur d'arc. Celui-ci est généralement associé à un dispositif d'intervention ou d'extinction d'arc, destiné à intervenir pour interrompre l'arc électrique et empêcher toute dégradation ou départ d'incendie.

Un arc électrique est réalisé par un plasma qui apparaît entre deux électrodes. Celles-ci peuvent être constituées par les deux extrémités d'un conducteur ou par deux parties d'un connecteur ouvert ou localement interrompu (du fait d'une corrosion par exemple). L'apparition d'un arc électrique s'accompagne d'un front ou saut positif de tension de courte durée, de l'ordre de quelques microsecondes. Ce saut de tension, appelé tension d'arc V_{arc}, a une valeur qui est caractéristique d'un arc électrique. La tension d'arc dépend du matériau des électrodes. Elle est généralement comprise entre 10V et 30V. Si les électrodes sont en cuivre par exemple, la tension d'arc V_{arc} est de l'ordre de 12V. Ainsi, une augmentation brutale, comprise entre 10V et 30V, d'une tension mesurée au sein d'une installation photovoltaïque révèle le plus souvent l'apparition d'un arc électrique dans l'installation. Le plasma de l'arc électrique jouant le rôle d'une résistance qui augmente au cours du temps, le front de tension initial est généralement suivi d'une augmentation progressive de la tension mesurée jusqu'à atteindre une tension en circuit ouvert.

Il existe diverses méthodes pour détecter un arc électrique dans une installation photovoltaïque. Une méthode connue s'appuie sur la détection d'un front ou saut de tension positif caractérisé par une augmentation brutale de tension, d'une durée de quelques microsecondes et d'une valeur correspondant à la tension d'arc V_{arc}, typiquement comprise entre 10V et 30V. A cet effet, on mesure par exemple la tension aux bornes d'un ou plusieurs modules photovoltaïques de l'installation.

L'arc électrique est un phénomène physique qui peut également se produire, en fonctionnement normal, dans un organe électromagnétique de commande et/ou de protection, à l'ouverture ou à la fermeture de contacts ou pôles. Par exemple, un interrupteur sectionneur génère, à l'ouverture, un arc électrique d'une durée inférieure ou égale à une durée maximale connue. Des moyens d'extinction d'arc peuvent permettre d'interrompre l'arc de manière à ce qu'il ne perdure pas au-delà d'une durée d'arc maximale X prédéfinie. Typiquement, la durée d'arc maximale X d'un interrupteur sectionneur est de l'ordre de quelques centaines de millisecondes pour un courant de plusieurs ampères, par exemple de 800ms pour un courant de 14A. Généralement, un arc électrique ayant une durée inférieure ou égale à cette durée d'arc X ne représente pas un risque de départ d'incendie dans le milieu dans lequel l'arc se produit.

Une installation photovoltaïque peut intégrer un ou plusieurs interrupteurs sectionneurs. Ceux-ci génèrent à l'ouverture un arc électrique qui est soufflé ou éteint par des moyens d'extinction d'arc, au plus tard à l'expiration d'une durée d'extinction d'arc prédéfinie. Un tel arc électrique peut toutefois être détecté par le dispositif de détection d'arc de l'installation photovoltaïque, si celui-ci a un temps de réaction très rapide, et déclencher une détection d'arc entraînant un arrêt intempestif total ou partiel de l'installation photovoltaïque.

Afin d'assurer un fonctionnement correct de l'installation photovoltaïque et éviter tout arrêt intempestif de celle-ci à l'ouverture d'un interrupteur sectionneur, le dispositif de détection d'arc ne doit pas déclencher en cas d'apparition d'un arc électrique lié à un fonctionnement normal de l'interrupteur sectionneur.

Le document K. Koziy et al. « A Low-Cost Power-Quality Meter With Series Arc-Fault Détection Capability for Smart Grid » IEEE transactions on power delivery, IEEE service center, New York, NY, US, vol. 28, no. 3, pages 1584-1591, XP011515987-1 juillet 2013, décrit un procédé de détection d'un arc électrique. Le document FR 3 002 645 décrit aussi un procédé de détection d'un arc électrique.

### Objet de l'invention

A cet effet, l'invention concerne un procédé de détection d'un arc électrique parasite dans une installation photovoltaïque comportant au moins un module photovoltaïque et un organe électromécanique susceptible de générer un arc électrique non parasite d'une durée inférieure ou égale à une durée d'extinction d'arc donnée, lors d'une ouverture de contacts dudit organe, caractérisé en ce qu'il comprend les étapes suivantes :
- Détection de l'apparition d'un arc électrique dans l'installation photovoltaïque ;
- Déclenchement d'un compteur de temps à compter d'un instant d'apparition de l'arc électrique ;
- Après expiration de la durée d'extinction d'arc à compter de l'instant d'apparition de l'arc, mesure de l'une au moins des grandeurs électriques du groupe comportant une tension dudit au moins un module photovoltaïque et un courant produit par l'installation ;
- Test de comparaison afin de déterminer si la grandeur électrique mesurée est égale à une tension en circuit ouvert du module photovoltaïque ou à un courant nul ;
- Si le test est négatif, identification d'un arc électrique parasite.

Par le terme « parasite », on entend désigner un arc électrique non lié à un fonctionnement normal de l'organe électromécanique, généralement lié à un défaut.

L'invention permet de différencier un arc électrique généré par l'ouverture en charge de contacts d'un organe électromécanique de l'installation photovoltaïque, non parasite, d'un arc électrique parasite, lié à un défaut. Grâce à cela, on évite de déclencher une détection positive d'arc électrique si l'arc électrique détecté est lié à l'ouverture de l'organe électromécanique, en fonctionnement normal.

Avantageusement, lors de l'étape de mesure, à l'expiration de la durée d'extinction d'arc, on mesure la tension dudit au moins un module photovoltaïque et le courant produit par l'installation, en ce qu'il comprend un premier test de comparaison afin de déterminer si la tension mesurée est égale à la tension en circuit ouvert du module photovoltaïque et un deuxième test de comparaison afin de déterminer si le courant mesuré est nul, et en ce qu'on détermine que l'arc électrique détecté est un arc parasite si l'un au moins des deux tests est négatif. L'identification d'un arc électrique parasite (ou non parasite) est ainsi encore plus fiable.

Dans un premier mode de réalisation, on détecte l'apparition d'un arc électrique par exécution d'un algorithme de détection d'un saut de tension caractéristique de l'apparition d'un arc électrique.

Dans un deuxième mode de réalisation, on détecte l'apparition d'un arc électrique par exécution d'un algorithme de détection d'un saut de courant caractéristique de l'apparition d'un arc électrique.

L'invention concerne aussi un dispositif de détection d'un arc électrique parasite destinée à équiper une installation photovoltaïque comportant au moins un module photovoltaïque et un organe électromécanique destiné à générer un arc électrique non parasite d'une durée inférieure ou égale à une durée d'extinction d'arc donnée, lors d'une ouverture en charge de contacts dudit organe, caractérisé en ce qu'il comprend :
- un module de détection de l'apparition d'un arc électrique dans l'installation photovoltaïque ;
- un compteur destiné à compter une durée écoulée à compter de l'instant d'apparition de l'arc électrique ;
- un capteur de mesure de l'une au moins des grandeurs électriques du groupe comportant une tension aux bornes du module photovoltaïque et un courant produit par l'installation, destiné à effectuer une mesure après expiration de la durée d'extinction d'arc à compter de l'instant d'apparition de l'arc ;
- un module de test destiné à réaliser un test de comparaison pour déterminer si la grandeur électrique mesurée est égale à une tension en circuit ouvert du module photovoltaïque ou à un courant nul ;
- un module d'identification de l'arc électrique détecté destiné à déterminer que l'arc électrique détecté est un arc parasite si le module de test fournit un résultat de test négatif.

Avantageusement, le dispositif comprend au moins un capteur de mesure de la tension dudit au moins un module photovoltaïque et un capteur de mesure du courant produit par l'installation, en ce que le module de test est destiné à réaliser un test de comparaison de la tension mesurée à la tension en circuit ouvert du module photovoltaïque et un test de comparaison du courant mesuré à un courant nul, et en ce que le module d'identification de l'arc électrique détecté est destiné à déterminer que l'arc électrique détecté est un arc parasite si le module de test fournit un résultat de test négatif pour l'un au moins des deux tests de comparaison réalisés.

Dans une première forme de réalisation, le dispositif comprend un module de détection de l'apparition d'un arc électrique par exécution d'un algorithme de détection d'un saut de tension caractéristique de l'apparition d'un arc électrique.

Dans une deuxième forme de réalisation, le dispositif comprend un module de détection de l'apparition d'un arc électrique par exécution d'un algorithme de détection d'un saut de courant caractéristique de l'apparition d'un arc électrique.

L'invention concerne également une installation photovoltaïque, caractérisée en ce qu'elle comprend un dispositif de détection d'arc électrique parasite.

L'invention concerne aussi un système de sécurité pour une installation photovoltaïque, caractérisé en ce qu'il comprend un dispositif de détection d'un arc électrique parasite tel que précédemment défini et un dispositif d'intervention destiné à mettre l'installation photovoltaïque en sécurité en cas d'arc électrique.

L'invention concerne enfin une installation photovoltaïque, caractérisée en ce qu'elle comprend un système de sécurité tel que défini ci-dessus.

### Description sommaire des dessins

L'invention sera mieux comprise à l'aide de la description suivante d'un mode de réalisation particulier du procédé de détection d'un arc électrique parasite et d'une forme de réalisation particulière d'un dispositif de détection d'un arc électrique parasite, d'un système de sécurité pour installation photovoltaïque et d'une installation photovoltaïque, selon l'invention, en référence aux dessins annexés sur lesquels :
- La figure 1 représente un schéma d'une installation photovoltaïque selon un exemple de réalisation de l'invention ;
- La figure 2 représente l'évolution temporelle schématique de la tension aux bornes d'un arc électrique généré à l'ouverture d'un organe électromagnétique et l'évolution temporelle schématique concomitante du courant produit par l'installation photovoltaïque de la figure 1 ;
- La figure 3 représente un exemple d'évolution temporelle de la tension d'un module photovoltaïque de l'installation photovoltaïque de la figure 1 en présence d'un arc électrique généré à l'ouverture d'un organe électromagnétique de l'installation ;
- La figure 4 représente l'évolution temporelle schématique de la tension aux bornes d'un arc électrique série de longue durée produit au sein de l'installation photovoltaïque et l'évolution temporelle schématique concomitante du courant produit par l'installation photovoltaïque ;
- La figure 5 représente un exemple d'évolution temporelle de la tension d'un module photovoltaïque de l'installation en présence d'un arc électrique série de longue durée ;
- La figure 6 représente l'évolution temporelle schématique de la tension aux bornes de multiples arcs série de courtes durées produits au sein de l'installation photovoltaïque et l'évolution temporelle schématique concomitante du courant produit par l'installation photovoltaïque ;
- La figure 7 représente un exemple d'évolution temporelle de la tension d'un module photovoltaïque de l'installation en présence de multiples arcs série de courtes durées ;
- La figure 8 représente un organigramme des étapes du procédé de détection d'un arc électrique parasite, selon un mode de réalisation particulier de l'invention ;
- La figure 9 représente un dispositif de détection d'un arc électrique parasite pour une installation photovoltaïque, selon une forme de réalisation particulière de l'invention, adapté pour mettre en œuvre le procédé de la figure 8.

### Description détaillée de modes de réalisation particuliers de l'invention

L'invention vise à déclencher une détection positive d'arc électrique au sein d'une installation photovoltaïque 100 uniquement si l'arc électrique est un arc parasite, c'est-à-dire lié à un défaut (par exemple un défaut d'un conducteur ou un défaut de connexion). Par opposition, un arc électrique « non parasite » est lié à un fonctionnement normal, non défectueux, de l'installation photovoltaïque 100 et ne représente a priori pas un risque pour la sécurité. Un arc électrique non parasite peut se produire à l'ouverture en charge (c'est-à-dire pendant qu'un courant électrique non nul circule) de contacts d'un organe électromécanique, par exemple d'un interrupteur sectionneur.

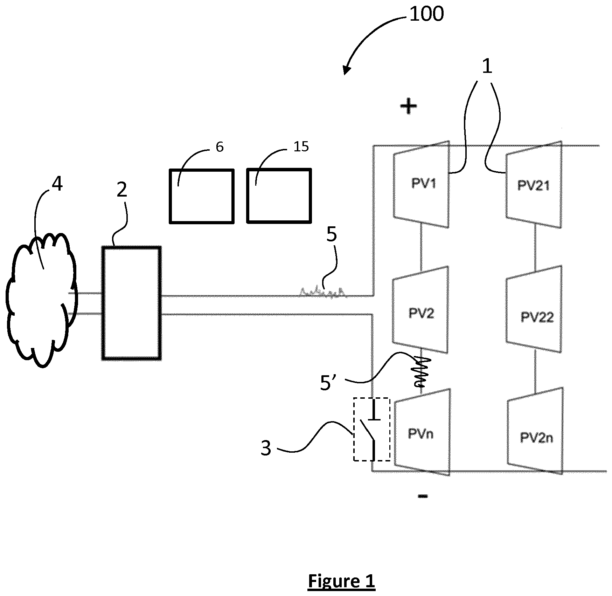

Sur la figure 1, on a représenté schématiquement un exemple d'installation photovoltaïque 100. Celle-ci comprend, de façon connue, plusieurs modules photovoltaïques (PV) 1 reliés à un onduleur 2 et un interrupteur sectionneur 3. Les modules PV 1 sont ici identiques. L'onduleur 2 est destiné à convertir le courant continu I produit par les modules photovoltaïques 2 en un courant alternatif et à fournir celui-ci à un réseau électrique 4. L'interrupteur sectionneur 3 a pour fonction d'interrompre le courant et d'isoler électriquement les parties à son amont et à son aval pour des opérations de maintenance par exemple.

Le procédé de l'invention cherche à détecter la présence ou non d'un arc électrique parasite, lié à un défaut, au sein d'une installation photovoltaïque 100, en évitant de détecter la présence d'un arc électrique non parasite. Un arc électrique parasite peut se produire en tout endroit de l'installation 100, par exemple entre les modules photovoltaïques 1 et l'onduleur 2 (comme représenté par l'arc électrique 5 sur la figure 1), ou au sein d'un module photovoltaïque 1, ou encore sur une liaison reliant en série plusieurs modules photovoltaïques 1 (comme représenté par l'arc électrique 5' sur la figure 1). Un arc électrique non parasite peut se produire en fonctionnement normal de l'installation 100, ici au sein de l'interrupteur sectionneur 3, à l'ouverture en charge des contacts de celui-ci.

Un arc électrique provoque une variation importante de la tension au sein de l'installation électrique 100. L'apparition de l'arc électrique se caractérise par un front ou saut positif de tension, d'une durée de l'ordre de quelques microsecondes et d'une amplitude égale à une tension d'arc initiale V_{arc0} caractéristique. La valeur de cette tension d'arc initiale V_{arc0} est typiquement de l'ordre de 20V, généralement comprise entre 10V et 30V. Elle dépend du matériau d'électrodes entre lesquelles l'arc électrique se forme. Lorsqu'un arc électrique apparaît dans l'installation photovoltaïque 100, qu'il s'agisse d'un arc électrique lié à un défaut (par exemple l'arc 5 ou 5') ou d'un arc électrique lié à l'ouverture en charge de l'interrupteur sectionneur 3, la tension aux bornes de chaque module photovoltaïque 1 augmente brutalement de la tension d'arc initiale V_{arc0} et le courant I produit par l'installation photovoltaïque diminue également brutalement d'une valeur I_{arc}. Cette valeur I_{arc} dépend de la position du point de fonctionnement sur la courbe courant tension, ou courbe caractéristique I-V, du module photovoltaïque et de son niveau d'éclairement.

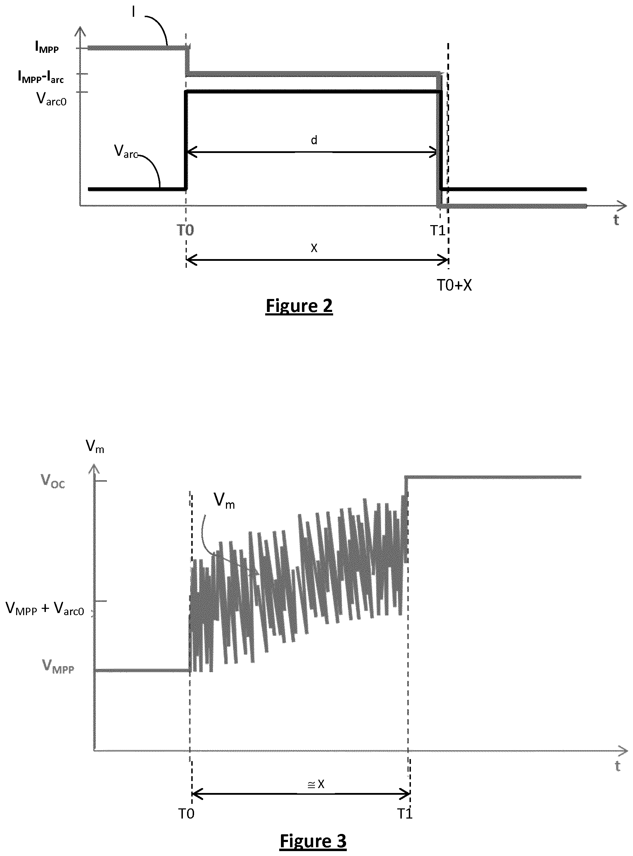

L'arc électrique qui se produit à l'ouverture en charge de l'interrupteur 3 possède des profils de tension et de courant qui sont caractéristiques, tels que représentés schématiquement sur la figure 2. Sur cette figure 2, les instants T0 et T1 représentent respectivement les instants d'apparition et de coupure (ou d'interruption) de l'arc électrique dans l'interrupteur 3. Supposons que les modules photovoltaïques 1 de l'installation 100 fonctionnent en leur point de puissance maximale ou MPP (de l'anglais « Maximal Power Point »), caractérisé par un courant I_{MPP} et une tension V_{MPP} A l'instant T0, la tension aux bornes de l'arc passe brutalement d'une valeur nulle ou quasi-nulle à une tension d'arc V_{arc0} et le courant produit par l'installation photovoltaïque 100 passe d'une valeur I_{MPP} à une valeur I_{MPP}-I_{arc}. La tension et le courant demeurent constants, ou sensiblement constants, et égaux respectivement à la tension V_{arc0} et au courant I_{MPP}-I_{arc} jusqu'à l'instant T1 de coupure de l'arc. La tension d'arc pourrait légèrement augmenter pendant les instants T0 et T1 du fait d'une augmentation de la résistance du plasma, entraînant une sensible diminution concomitante du courant I. La durée d entre les instants T0 et T1 est inférieure ou égale à une durée prédéfinie d'extinction d'arc X (ici d est sensiblement inférieure à X). Puis, à compter de l'instant T1, la tension de l'arc repasse à une valeur nulle ou quasi-nulle et le courant de l'installation devient nul (l'interrupteur 3 étant ouvert). Sur la figure 3, on a représenté l'évolution dans le temps de la tension Vₘ aux bornes d'un module photovoltaïque 1 lorsque l'arc électrique se produit à l'ouverture de l'interrupteur sectionneur 3. A l'instant T0, la tension Vₘ passe brutalement de la tension V_{MPP} du point puissance maximale du module 1 à une tension d'arc V_{MPP}+V_{arc0}, par un premier front positif de tension. A l'instant T1, du fait de la disparition de l'arc et de l'ouverture de l'interrupteur sectionneur 3, la tension Vₘ passe brutalement à la tension V_{OC} en circuit ouvert du module photovoltaïque 1. Entre les deux instants T0 et T1, la tension Vₘ augmente ici légèrement du fait de l'augmentation de la résistance du plasma.

Il existe deux principaux types d'arcs électriques parasites, liés à des défauts dans l'installation photovoltaïque 100 :
- les arcs électriques série de longue durée et
- les arcs électriques série multiples de courtes durées.

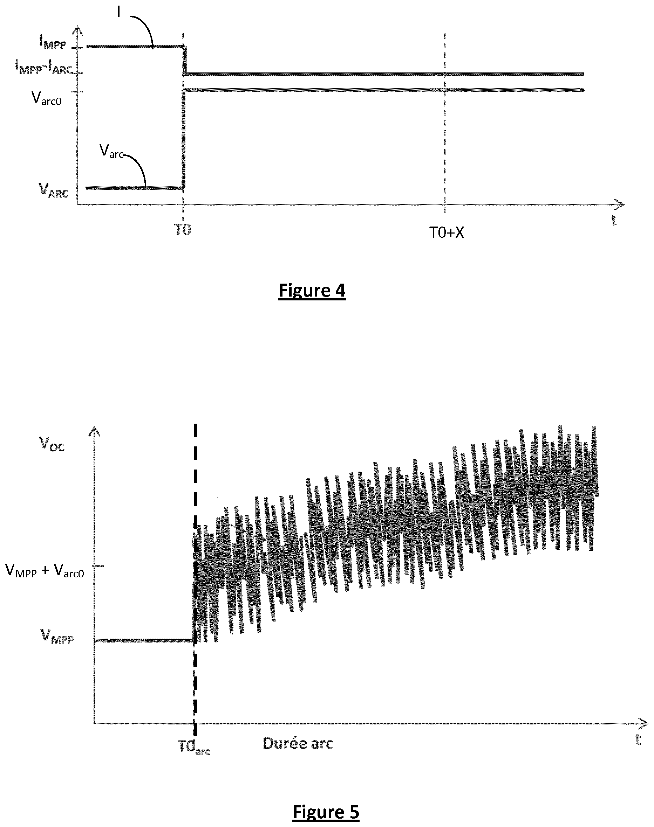

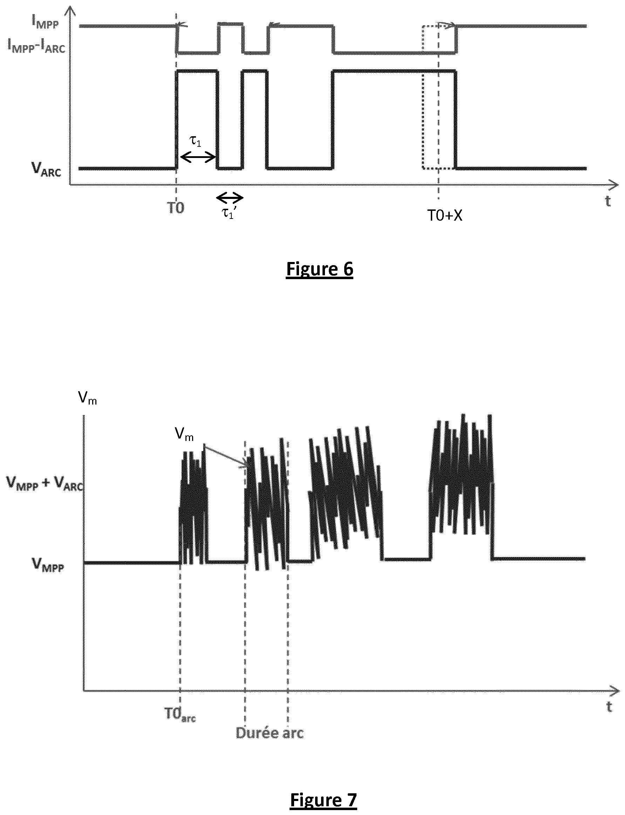

Sur les figures 4 et 6, on a représenté schématiquement les profils de courant et de tension de ces deux types d'arcs.

La figure 4 représente le profil de courant et de tension d'un arc électrique série de longue durée. A l'instant T0 (apparition de l'arc électrique), la tension aux bornes de l'arc passe brutalement d'une valeur nulle ou quasi-nulle à une tension d'arc initiale V_{arc0} et le courant I produit par l'installation photovoltaïque 100 passe de la valeur I_{MPP} à une valeur I_{MPP}-I_{arc}. La tension et le courant demeurent constants, ou sensiblement constants, et égaux respectivement à la tension V_{arc0} et au courant I_{MPP}-I_{arc} pendant une durée qui excède la durée X d'extinction d'arc de l'interrupteur 3. La tension pourrait toutefois augmenter progressivement au cours du temps, du fait d'une augmentation de la résistance du plasma et entraîner une diminution progressive concomitante du courant I. Sur la figure 5, on a représenté l'évolution dans le temps de la tension Vₘ aux bornes d'un module photovoltaïque 1 lorsqu'un arc électrique série de longue durée se produit dans l'installation 100. A l'instant T0, la tension Vₘ passe brutalement de la tension V_{MPP} à une tension d'arc V_{MPP}+V_{arc0}, par un front positif de tension. Puis la tension Vₘ stagne ou augmente légèrement de façon progressive, cette évolution se poursuivant au-delà de la durée X à compter du front.

La figure 6 représente le profil de courant et de tension d'arcs électriques série multiples de courtes durées. Les arcs électriques de ce type sont liés à des défauts de connexion (oxydation de contact, rupture de soudure, desserrage de bornier, etc.). En présence de tels défauts de connexion, des électrodes se forment mais restent par construction très proches l'une de l'autre, voire même en contact aléatoire, ce qui induit des connexions électriques aléatoires. Un arc électrique peut apparaître entre ces électrodes, durer quelques microsecondes à quelques centaines de microsecondes. Par fusion des matériaux d'électrode, un pont de soudure peut se créer, rétablissant ainsi le contact électrique entre les électrodes, puis se rompre à nouveau sous l'effet joule du courant provoquant ainsi l'apparition d'un nouvel arc. Ce processus d'apparition et de disparition d'arc peut se répéter à plusieurs reprises et générer ainsi une succession d'arcs électriques de courtes durées séparés par des périodes sans arc.

En référence à la figure 6, à l'instant T0 (apparition d'un premier arc électrique), la tension aux bornes de l'arc passe brutalement d'une valeur nulle ou quasi-nulle à une tension d'arc V_{arc0} et le courant produit par l'installation photovoltaïque 100 passe d'une valeur I_{MPP} à une valeur I_{MPP}-I_{arc}. La tension et le courant demeurent constants, ou sensiblement constants, et égaux respectivement à la tension V_{arc0} et au courant I_{MPP}-I_{arc} pendant une courte durée τ₁ (inférieure à la durée X) puis la tension repasse à une tension nulle ou quasi-nulle et le courant à un courant I_{MPP} pendant une durée τ₁'. Une telle séquence se reproduit de multiples fois, l'une à la suite de l'autre, avec des durées τ₁ et τ₁' variables. Sur la figure 7, on a représenté l'évolution dans le temps de la tension Vₘ aux bornes d'un module photovoltaïque 1 lorsque des arcs électriques série de courtes durées se produisent : la tension, initialement égale à V_{MPP}, passe pendant une durée τ₁ à V_{MPP}+V_{arc0}, puis repasse à V_{MPP} pendant une durée τ₁', cette séquence se reproduisant plusieurs fois avec des durées τ₁ et τ₁' variables. Un tel cumul de temps courts d'arcs électriques génère un échauffement très important pouvant occasionner un début d'incendie.

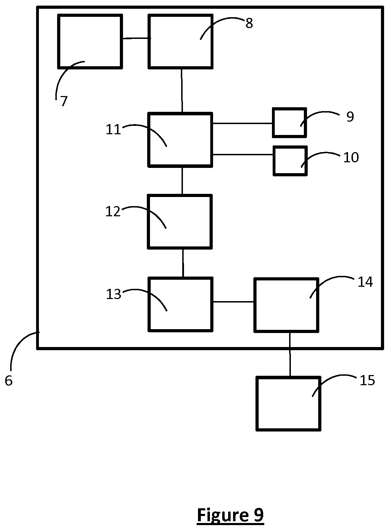

L'installation photovoltaïque 100 comprend un dispositif 6 de détection d'arc électrique parasite. En référence à la figure 9, le dispositif de détection 6 comprend ici :
- un module 7 de détection de l'apparition d'un arc électrique dans l'installation photovoltaïque ;
- un compteur 8 destiné à compter une durée écoulée à compter de l'instant d'apparition de l'arc électrique ;
- un ou plusieurs capteurs 9 de mesure de tension aux bornes d'un ou plusieurs modules photovoltaïques 1 de l'installation photovoltaïque 100 ;
- un capteur 10 de mesure de courant produit par l'installation photovoltaïque 100 ;
- un module de contrôle 11 destiné à commander des mesures de tension et de courant par les capteurs 9 et 10 ;
- un module de test 12 destiné à réaliser un test de comparaison de la tension mesurée avec une tension en circuit ouvert V_{OC} du module photovoltaïque 1 et un test de comparaison du courant mesuré avec un courant nul ;
- un module 13 d'identification de l'arc électrique détecté destiné à déterminer s'il s'agit d'un arc électrique parasite ou d'un arc électrique lié à l'ouverture en charge de l'interrupteur 3 ;
- des mémoires de stockage (non représentées) ;
- une unité de traitement 14, en l'espèce un microprocesseur.

Les modules 7, 8, 11, 12 et 13 sont ici des composants logiciels destinés à être exécutés par le microcontrôleur 14. Les composants matériels et/ou logiciels de l'unité de traitement 14 sont adaptés pour mettre en œuvre le procédé décrit plus loin.

Le module 7 de détection de l'apparition d'un arc électrique est agencé pour mettre en œuvre une méthode connue de détection d'arc électrique capable de détecter rapidement l'apparition d'un arc électrique, de préférence dans un délai maximal de quelques centaines de microsecondes après cette apparition. La méthode de détection peut reposer sur la détection d'un saut de tension, comme décrit par exemple dans le document brevet FR3002645, ou sur la détection d'un saut de courant, comme décrit dans la demande de brevet français déposée sous le numéro 1561622. Le module de détection 7 est relié à un ou plusieurs capteurs de mesure de tension ou de courant, selon la méthode mise en œuvre, par des liaisons de communication. Il peut par exemple être relié aux capteurs 9 ou au capteur 10.

Le compteur 8 est destiné à mesurer la durée écoulée à partir d'un instant T0 d'apparition d'un arc électrique détecté par le module 7.

Le module de contrôle 11 est destiné à commander des mesures de tension et de courant par les capteurs 9 et 10 à l'issue d'une durée écoulée à compter de l'instant T0 d'apparition de l'arc électrique détecté, qui est supérieure ou égale à une durée d'extinction d'arc connue X, qui est typiquement de l'ordre de 10ms ou de quelques dizaines de millisecondes.

Le module de test 12 est ici destiné à exécuter deux tests, l'un (test de tension) sur la tension mesurée par le capteur 9, l'autre (test de courant) sur le courant mesuré par le capteur 10. Si plusieurs capteurs 9 mesurent les tensions aux bornes de plusieurs modules photovoltaïques 1, le module de test exécute un test de tension pour chaque tension mesurée. Le test de tension consiste à comparer la tension du module photovoltaïque mesurée à la tension en circuit ouvert V_{OC} de ce module afin de déterminer si la tension mesurée est égale à V_{OC}. Le test de courant consiste à déterminer si le courant mesuré de l'installation photovoltaïque est nul. Le module de test pourrait ne réaliser que l'un des deux types de tests (courant ou tension).

Le module d'identification 13 est destiné à identifier le caractère « parasite » ou « non parasite » de l'arc électrique détecté, autrement dit à déterminer si l'arc électrique détecté est un arc électrique parasite (a priori lié à un défaut) ou un arc électrique non parasite (lié a priori à l'ouverture en charge de l'interrupteur 3), en fonction des résultats de tests de tension et/ou de courant.

Tous les éléments du dispositif de détection 6 sont reliés à l'unité de traitement 14, qui est adaptée pour en contrôler le fonctionnement. L'unité de traitement 14 est destinée à exécuter les différents modules logiciels du dispositif 6. Elle a également pour fonction de transmettre une commande de mise en sécurité à un dispositif d'intervention 15, en cas de détection d'un arc électrique parasite.

Le dispositif de détection 6 est relié au dispositif d'intervention 15 par une liaison de communication 17. Le dispositif d'intervention 15 a pour fonction d'interrompre un arc électrique parasite détecté par le dispositif de détection 6, sur commande de celui-ci, afin d'éviter tout risque de détérioration ou d'incendie.

Le dispositif 6 de détection d'arc électrique parasite et le dispositif d'intervention 12 forment un système de sécurité pour installation photovoltaïque 100.

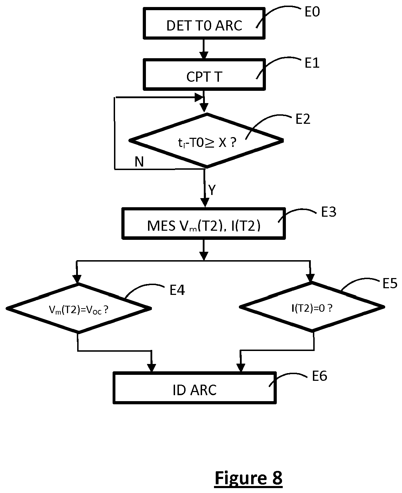

En référence à la figure 8, on va maintenant décrire un procédé de détection d'un arc électrique parasite dans l'installation photovoltaïque 100.

Le procédé comprend une première étape E0 de détection de l'apparition d'un arc électrique dans l'installation photovoltaïque, réalisée par le module de détection 7. Cette étape de détection peut être mise en œuvre par exécution de toute méthode connue de détection d'un arc électrique, adaptée pour détecter l'arc rapidement, de préférence dans un délai maximal de quelques centaines de microsecondes après son apparition. Par exemple, la détection de l'arc électrique est réalisée selon la méthode de détection décrite dans le document brevet FR3002645. En variante, on pourrait détecter l'apparition d'un arc électrique par exécution d'un algorithme de détection d'un saut de courant caractéristique de l'apparition d'un arc électrique, comme décrit dans la demande de brevet français déposée sous le numéro 1561622.

Notons T0 l'instant d'apparition de l'arc électrique. Cet instant T0 est détecté lors de l'étape E0.

A l'instant T0, lors d'une étape E1, le compteur 8 est déclenché afin de mesurer le temps à compter de l'apparition de l'arc électrique détecté, lors d'une étape E1.

Le module de contrôle 11 exécute ensuite une étape de test E2 à une succession d'instants tᵢ postérieurs à T0, afin de vérifier si la durée entre T0 et tᵢ est supérieure ou égale à la durée X d'extinction d'arc. L'étape E2 est réitérée pour des instants tᵢ successifs tant que le test est négatif. Si le test est positif à un instant tᵢ=T2, la durée entre les instants T0 et T2 étant supérieure ou égale à la durée X d'extinction d'arc, le procédé passe à une étape de mesure E3.

Lors de l'étape E3, sur commande du module de contrôle 11, les capteurs 9 et 10 mesurent la tension Vₘ(T2) aux bornes d'au moins un module photovoltaïque 1 de l'installation 100 et le courant I(T2) produit par l'installation 100 à l'instant T2. En variante, la tension Vₘ et le courant I peuvent être mesurés peu après cet instant T2.

Le procédé se poursuit par deux étapes de test E4 et E5, réalisées par le module de test 12.

Lors de l'étape de test E4, le module 12 réalise un test de comparaison de la tension mesurée Vₘ(T2) avec la tension en circuit ouvert V_{OC} du module photovoltaïque 1. Ce test de tension consiste à déterminer si la tension mesurée Vₘ(T2) est égale à la tension en circuit ouvert V_{OC}. Si Les tensions aux bornes de plusieurs modules photovoltaïques 1 sont mesurées, le test de tension est exécuté pour chacune des tensions mesurées. Le test est positif si la tension mesurée Vₘ(T2) est égale à la tension en circuit ouvert V_{OC}, et négatif sinon. On pourrait accepter une certaine marge de précision et considérer que le test E4 est positif si la Vₘ(T2) est égale à la tension en circuit ouvert V_{OC} + ou - 10% de V_{OC}.

Lors de l'étape de test E5, le module 12 réalise un test de comparaison du courant mesuré I(T2) avec un courant nul. Ce test de courant consiste à déterminer si le courant I(T2) est nul, le test étant positif si le courant I(T2) est nul et négatif sinon. On pourrait accepter une certaine marge de précision et considérer que le test est positif si le courant I(T2) est inférieur à 10% de I_{MPP} (courant du point de puissance maximale).

Les deux tests E4 et E5 sont suivis d'une étape E6 d'identification de l'arc électrique détecté consistant à déterminer s'il s'agit d'un arc parasite (lié à un défaut) ou d'un d'arc non parasite (lié à l'ouverture en charge de l'interrupteur 3), réalisée par le module 13. Si l'un au moins des deux tests est négatifs, autrement dit si la tension mesurée Vₘ(T2) est différente de la tension V_{OC} (éventuellement à 10% près) et/ou si le courant mesuré I(T2) n'est pas nul (ou éventuellement sensiblement nul, inférieur à 10% de I_{MPP}), il est déterminé que l'arc électrique détecté est un arc parasite. Si les deux tests sont positifs, autrement dit si la tension mesurée Vₘ(T2) est égale à la tension V_{OC} et si le courant mesuré I(T2) est nul, il est déterminé que l'arc électrique détecté est un arc non parasite, lié ici à l'ouverture en charge de l'interrupteur 3.

Lorsqu'un arc électrique parasite est détecté, l'unité de traitement 14 envoie automatiquement au dispositif d'intervention 15 une commande de mise en sécurité de l'installation 100, lors d'une étape E7. Lors d'une étape E8, le dispositif d'intervention 15 met en sécurité l'installation photovoltaïque 100. Cette mise en sécurité peut reposer sur des interrupteurs commandés à distance. Elle peut consister en un ordre d'interruption du fonctionnement de l'installation photovoltaïque, ce qui permet de stopper l'arc électrique parasite et de supprimer tout risque de dégradation et/ou de début d'incendie.

Dans le mode de réalisation du procédé précédemment décrit, on mesure la tension aux bornes d'au moins un module photovoltaïque 1 et le courant produit par l'installation photovoltaïque 100 à l'instant T2. En variante, on pourrait mesurer l'une seule de ces deux grandeurs électriques, par exemple soit la tension Vₘ(T2) soit le courant I(T2), tester uniquement la valeur mesurée (avec la tension V_{OC} pour la tension Vₘ(T2) mesurée, et avec un courant nul pour le courant I(T2) mesuré), et déterminer si l'arc électrique détecté est un arc parasite ou non parasite selon que le test est négatif ou positif respectivement.

Le procédé de détection d'arc électrique qui vient d'être décrit permet de différencier un arc électrique généré par un interrupteur sectionneur d'une installation photovoltaïque, à l'ouverture des contacts de l'interrupteur, d'un arc électrique lié à un défaut. Plus généralement, le procédé de l'invention permet la différentiation d'un arc électrique généré par un organe électromécanique susceptible de générer un arc électrique à l'ouverture et/ou à la fermeture en charge de contacts de l'organe, d'un arc électrique lié à un défaut. L'organe électromécanique peut par exemple être un interrupteur, un contacteur ou encore un disjoncteur.

## Revendications

1. Procédé de détection d'un arc électrique parasite dans une installation photovoltaïque (100) comportant au moins un module photovoltaïque (1) et un organe électromécanique (3) susceptible de générer un arc électrique non parasite d'une durée inférieure ou égale à une durée (X) d'extinction d'arc donnée, lors d'une ouverture de contacts dudit organe (3), **caractérisé en ce qu'**il comprend les étapes suivantes :
- Détection (E0) de l'apparition d'un arc électrique dans l'installation photovoltaïque (100) ;
- Déclenchement (E1) d'un compteur de temps à compter d'un instant (T0) d'apparition de l'arc électrique ;
- Après expiration de la durée (X) d'extinction d'arc à compter de l'instant (T0) d'apparition de l'arc, mesure (E3) de l'une au moins des grandeurs électriques du groupe comportant une tension (Vₘ) dudit au moins un module photovoltaïque (1) et un courant (I) produit par l'installation (100) ;
- Test de comparaison (E4 ; E5) afin de déterminer si la grandeur électrique mesurée est égale à une tension en circuit ouvert (Voc) du module photovoltaïque ou à un courant nul ;
- Si le test est négatif, identification d'un arc électrique parasite.

2. Procédé selon la revendication 1, **caractérisé en ce que**, lors de l'étape de mesure (E3) à l'expiration de la durée d'extinction d'arc, on mesure la tension dudit au moins un module photovoltaïque et le courant produit par l'installation, **en ce qu'**il comprend un premier test de comparaison (E4) afin de déterminer si la tension mesurée est égale à la tension en circuit ouvert du module photovoltaïque et un deuxième test (E5) de comparaison afin de déterminer si le courant mesuré est nul, et **en ce qu'**on détermine (E6) que l'arc électrique détecté est un arc parasite si l'un au moins des deux tests est négatif.

3. Procédé selon l'une des revendications précédentes, **caractérisé en ce qu'**on détecte (E0) l'apparition d'un arc électrique par exécution d'un algorithme de détection d'un saut de tension caractéristique de l'apparition d'un arc électrique.

4. Procédé selon l'une des revendications précédentes, **caractérisé en ce qu'**on détecte (E0) l'apparition d'un arc électrique par exécution d'un algorithme de détection d'un saut de courant caractéristique de l'apparition d'un arc électrique.

5. Dispositif de détection d'un arc électrique parasite pour une installation photovoltaïque (100) comportant au moins un module photovoltaïque (1) et un organe électromécanique (3) destiné à générer un arc électrique non parasite d'une durée inférieure ou égale à une durée d'extinction d'arc donnée, lors d'une ouverture en charge de contacts dudit organe, **caractérisé en ce qu'**il comprend :
- un module (7) de détection de l'apparition d'un arc électrique dans l'installation photovoltaïque ;
- un compteur (8) destiné à compter une durée écoulée à compter de l'instant d'apparition de l'arc électrique ;
- un capteur (9 ; 10) de mesure de l'une au moins des grandeurs électriques du groupe comportant une tension aux bornes du module photovoltaïque (1) et un courant produit par l'installation (100), destiné à effectuer une mesure après expiration de la durée (X) d'extinction d'arc à compter de l'instant (T0) d'apparition de l'arc ;
- un module de test (12) destiné à réaliser un test de comparaison pour déterminer si la grandeur électrique mesurée est égale à une tension en circuit ouvert du module photovoltaïque ou à un courant nul ;
- un module (13) d'identification de l'arc électrique détecté destiné à déterminer que l'arc électrique détecté est un arc parasite si le module de test fournit un résultat de test négatif.

6. Dispositif selon la revendication précédente, **caractérisé en ce qu'**il comprend au moins un capteur (9) de mesure de la tension dudit au moins un module photovoltaïque et un capteur (10) de mesure du courant produit par l'installation, **en ce que** le module de test (12) est destiné à réaliser un test de comparaison de la tension mesurée à la tension en circuit ouvert du module photovoltaïque et un test de comparaison du courant mesuré à un courant nul, et **en ce que** le module (13) d'identification de l'arc électrique détecté est destiné à déterminer que l'arc électrique détecté est un arc parasite si le module de test fournit un résultat de test négatif pour l'un au moins des deux tests de comparaison réalisés.

7. Dispositif selon l'une des revendications 5 et 6, **caractérisé en ce qu'**il comprend un module (7) de détection de l'apparition d'un arc électrique par exécution d'un algorithme de détection d'un saut de tension caractéristique de l'apparition d'un arc électrique.

8. Dispositif selon l'une des revendications 5 et 6, **caractérisé en ce qu'**il comprend un module de détection de l'apparition d'un arc électrique par exécution d'un algorithme de détection d'un saut de courant caractéristique de l'apparition d'un arc électrique.

9. Installation photovoltaïque, **caractérisée en ce qu'**elle comprend un dispositif de détection d'arc électrique parasite selon l'une des revendications 5 à 8.

10. Système de sécurité pour une installation photovoltaïque, **caractérisé en ce qu'**il comprend un dispositif de détection d'un arc électrique parasite selon l'une des revendications 5 à 8 et un dispositif d'intervention destiné à mettre l'installation photovoltaïque en sécurité en cas d'arc électrique.

11. Installation photovoltaïque, **caractérisée en ce qu'**elle comprend un système de sécurité selon la revendication 10.

## Patentansprüche

1. Verfahren zur Erkennung eines Störlichtbogens in einer Photovoltaikanlage (100) mit mindestens einem Photovoltaikmodul (1) und einem elektromechanischen Element (3), das bei einem Öffnen von Kontakten des Elements (3) einen nicht störenden Lichtbogen mit einer Dauer von höchstens einer gegebenen Lichtbogenlöschdauer (X) generieren könnte, **dadurch gekennzeichnet, dass** es die folgenden Schritte umfasst:
- Erkennen (E0) des Auftretens eines elektrischen Lichtbogens in einer Photovoltaikanlage (100);
- Auslösen (E1) eines Zeitzählers ab einem Zeitpunkt (T0) des Auftretens des Lichtbogens;
- Messen (E3), nach Ablauf der Lichtbogenlöschdauer (X) ab dem Zeitpunkt (T0) des Auftretens des Lichtbogens, mindestens einer der elektrischen Größen aus der Gruppe, die eine Spannung (Vₘ) des mindestens einen Photovoltaikmoduls (1) und einen von der Anlage (100) erzeugten Strom (I) umfasst;
- Vergleichstest (E4; E5), um festzustellen, ob die gemessene elektrische Größe gleich einer Leerlaufspannung (V_{OC}) des Photovoltaikmoduls oder einem Nullstrom ist;
- Falls der Test negativ ist, Identifizieren eines Störlichtbogens.

2. Verfahren nach Anspruch 1, **dadurch gekennzeichnet, dass** man beim Schritt des Messens (E3) bei Ablauf der Lichtbogenlöschdauer die Spannung des mindestens einen Photovoltaikmoduls und den von der Anlage erzeugten Strom misst, dass es einen ersten Vergleichstest (E4), um festzustellen, ob die gemessene Spannung gleich der Leerlaufspannung des Photovoltaikmoduls ist, und einen zweiten Vergleichstest (E5), um festzustellen, ob der gemessene Strom null ist, umfasst, und dass man feststellt (E6), dass der erkannte Lichtbogen ein Störlichtbogen ist, wenn mindestens einer der beiden Tests negativ ist.

3. Verfahren nach einem der vorhergehenden Ansprüche, **dadurch gekennzeichnet, dass** man das Auftreten eines Lichtbogens durch Ausführen eines Algorithmus zur Erkennung eines für das Auftreten eines Lichtbogens charakteristischen Spannungssprungs erkennt (E0).

4. Verfahren nach einem der vorhergehenden Ansprüche, **dadurch gekennzeichnet, dass** man das Auftreten eines Lichtbogens durch Ausführen eines Algorithmus zur Erkennung eines für das Auftreten eines Lichtbogens charakteristischen Stromsprungs erkennt (E0).

5. Vorrichtung zur Erkennung eines Störlichtbogens für eine Photovoltaikanlage (100) mit mindestens einem Photovoltaikmodul (1) und einem elektromechanischen Element (3), das dazu bestimmt ist, bei einem Öffnen unter Last von Kontakten des Elements einen nicht störenden Lichtbogen mit einer Dauer von höchstens einer gegebenen Lichtbogenlöschdauer zu generieren, **dadurch gekennzeichnet, dass** sie umfasst:
- ein Modul (7) zum Erkennen des Auftretens eines Lichtbogens in einer Photovoltaikanlage;
- einen Zähler (8), der dazu bestimmt ist, eine ab dem Zeitpunkt des Auftretens des Lichtbogens verstrichene Zeitdauer zu zählen;
- einen Sensor (9; 10) zum Messen mindestens einer der elektrischen Größen aus der Gruppe, die eine Spannung an den Klemmen des Photovoltaikmoduls (1) und einen von der Anlage erzeugten Strom (100) umfasst, der dazu bestimmt ist, nach Ablauf der Lichtbogenlöschdauer (X) ab dem Zeitpunkt (T0) des Auftretens des Lichtbogens eine Messung durchzuführen;
- ein Testmodul (12), das dazu bestimmt ist, einen Vergleichstest durchzuführen, um festzustellen, ob die gemessene elektrische Größe gleich einer Leerlaufspannung des Photovoltaikmoduls oder einem Nullstrom ist;
- ein Modul (13) zur Identifizierung des erkannten Lichtbogens, das dazu bestimmt ist festzustellen, dass der erkannte Lichtbogen ein Störlichtbogen ist, wenn das Testmodul ein negatives Testergebnis ausgibt.

6. Vorrichtung nach dem vorhergehenden Anspruch, **dadurch gekennzeichnet, dass** sie mindestens einen Sensor (9) zum Messen der Spannung des mindestens einen Photovoltaikmoduls und einen Sensor (10) zum Messen des von der Anlage erzeugten Stroms umfasst, dass das Testmodul (12) dazu bestimmt ist, einen Test zum Vergleichen der gemessenen Spannung mit der Leerlaufspannung des Photovoltaikmoduls und einen Test zum Vergleichen des gemessenen Stroms mit einem Nullstrom auszuführen, und dass das Modul (13) zur Identifizierung des erkannten Lichtbogens dazu bestimmt ist festzustellen, dass der erkannte Lichtbogen ein Störlichtbogen ist, wenn das Testmodul für mindestens einen der beiden ausgeführten Vergleichstests ein negatives Testergebnis ausgibt.

7. Vorrichtung nach einem der Ansprüche 5 und 6, **dadurch gekennzeichnet, dass** sie ein Modul (7) zur Erkennung des Auftretens eines Lichtbogens durch Ausführen eines Algorithmus zur Erkennung eines für das Auftreten eines Lichtbogens charakteristischen Spannungssprungs umfasst.

8. Vorrichtung nach einem der Ansprüche 5 und 6, **dadurch gekennzeichnet, dass** sie ein Modul zur Erkennung des Auftretens eines Lichtbogens durch Ausführen eines Algorithmus zur Erkennung eines für das Auftreten eines Lichtbogens charakteristischen Stromsprungs umfasst.

9. Photovoltaikanlage, **dadurch gekennzeichnet, dass** sie eine Vorrichtung zur Erkennung eines Störlichtbogens nach einem der Ansprüche 5 bis 8 umfasst.

10. Sicherheitssystem für eine Photovoltaikanlage, **dadurch gekennzeichnet, dass** es eine Vorrichtung zur Erkennung eines Störlichtbogens nach einem der Ansprüche 5 bis 8 und eine Vorrichtung zum Eingreifen, die dazu dient, die Photovoltaikanlage im Fall eines Lichtbogens zu sichern, umfasst.

11. Photovoltaikanlage, **dadurch gekennzeichnet, dass** sie ein Sicherheitssystem nach Anspruch 10 umfasst.

## Claims

1. A method for detecting a stray electric arc in a photovoltaic installation (100) including at least one photovoltaic module (1) and an electromechanical unit (3) liable to generate a non-stray electric arc of a duration less than or equal to a given arc-quenching duration (X), upon opening of contacts of said unit (3), **characterized in that** it comprises the following steps:
- Detecting (E0) the appearance of an electric arc in the photovoltaic installation (100);
- Triggering (E1) a timer starting from an instant (T0) of appearance of the electric arc;
- After expiry of the arc-quenching duration (X) starting from the instant (T0) of appearance of the arc, measuring (E3) at least one of the electrical values from the group including a voltage (Vₘ) of said at least one photovoltaic module (1) and a current (I) produced by the installation (100) ;
- A comparison test (E4; E5) in order to determine whether the measured electrical value is equal to an open circuit voltage (Voc) of the photovoltaic module or to a zero current;
- If the test is negative, identifying a stray electric arc.

2. The method as claimed in claim 1, **characterized in that**, in the measurement step (E3), upon expiry of the arc-quenching duration, the voltage of said at least one photovoltaic module and the current produced by the installation are measured, **in that** it comprises a first comparison test (E4) in order to determine whether the measured voltage is equal to the open circuit voltage of the photovoltaic module and a second comparison test (E5) in order to determine whether the measured current is zero, and **in that** it is determined (E6) that the detected electric arc is a stray arc if at least one of the two tests is negative.

3. The method as claimed in either of the preceding claims, **characterized in that** the appearance of an electric arc is detected (E0) by executing an algorithm for detecting a voltage jump characteristic of the appearance of an electric arc.

4. The method as claimed in one of the preceding claims, **characterized in that** the appearance of an electric arc is detected (E0) by executing an algorithm for detecting a current jump characteristic of the appearance of an electric arc.

5. A device for detecting a stray electric arc, for a photovoltaic installation (100) including at least one photovoltaic module (1) and an electromechanical unit (3) intended to generate a non-stray electric arc of a duration less than or equal to a given arc-quenching duration, upon opening of contacts of said unit when live, **characterized in that** it comprises:
- a module (7) for detecting the appearance of an electric arc in the photovoltaic installation;
- a timer (8) intended to time a lapsed duration starting from the instant of appearance of the electric arc;
- a sensor (9; 10) for measuring at least one of the electrical values from the group including a voltage across the terminals of the photovoltaic module (1) and a current produced by the installation (100), intended to perform a measurement after expiry of the arc-quenching duration (X) starting from the instant (T0) of appearance of the arc;
- a test module (12) intended to carry out a comparison test in order to determine whether the measured electrical value is equal to an open circuit voltage of the photovoltaic module or to a zero current;
- a module (13) for identifying the detected electric arc, intended to determine that the detected electric arc is a stray arc if the test module supplies a negative test result.

6. The device as claimed in the preceding claim, **characterized in that** it comprises at least one sensor (9) for measuring the voltage of said at least one photovoltaic module and a sensor (10) for measuring the current produced by the installation, **in that** the test module (12) is intended to carry out a test of comparing the measured voltage with the open circuit voltage of the photovoltaic module and a test of comparing the measured current with a zero current, and **in that** the module (13) for identifying the detected electric arc is intended to determine that the detected electric arc is a stray arc if the test module supplies a negative test result for at least one of the two comparison tests that are carried out.

7. The device as claimed in either of claims 5 and 6, **characterized in that** it comprises a module (7) for detecting the appearance of an electric arc by executing an algorithm for detecting a voltage jump characteristic of the appearance of an electric arc.

8. The device as claimed in either of claims 5 and 6, **characterized in that** it comprises a module for detecting the appearance of an electric arc by executing an algorithm for detecting a current jump characteristic of the appearance of an electric arc.

9. A photovoltaic installation, **characterized in that** it comprises a device for detecting a stray electric arc as claimed in one of claims 5 to 8.

10. A safety system for a photovoltaic installation, **characterized in that** it comprises a device for detecting a stray electric arc as claimed in one of claims 5 to 8 and an intervention device intended to protect the photovoltaic installation in the event of an electric arc.

11. A photovoltaic installation, **characterized in that** it comprises a safety system as claimed in claim 10.
